# EUROPEAN PATENT APPLICATION

(11) **EP 1 580 479 A1**
(43) Date of publication of application: **28.09.2005**
(21) Application number: 03812370.9
(22) Date of filing: 02.12.2003
(51) Int. Cl.: F17D 1/08, H01L 21/31, F16K 27/00

(54) **RAW SOLUTION FEEDING SYSTEM FOR VAPORIZER AND METHOD OF CLEANING THE RAW SOLUTION FEEDING SYSTEM**

(30) Priority: 02.12.2002 JP 2002350438
(71) Applicant: KABUSHIKI KAISHA WATANABE SHOKO, Tokyo 103-0022 (JP)
(72) Inventor: FUKAGAWA, Mitsuru, Wacom Electric Co., Ltd, Chuo-ku, Tokyo 103-0022 (JP)
(74) Representative: Dr. Weitzel & Partner
(86) International application number: PCT/JP2003/015405
(87) International publication number: WO 2004/051139

(57) **Abstract**

A monoblock valve that enables performing cleaning of not only the interior thereof but also raw solution feeding lines easily within a short period of time is provided. A monoblock valve that minimizes the residue of by-products or reaction products is provided. Not only the retention zone provided in the valve but also the internal volume of the valve is reduced. The connection between constituent members of a liquid material feeding tank, a liquid material vaporizer, etc. is accomplished by direct valve connection to such constituent members by means of a metallic sealing member with the intent to reduce the internal volume of piping.

## Description

### Technical Field

In recent years, the present invention relates to a shut-off valve which is used in a piping system constituting an apparatus for manufacturing a semiconductor memory device or a semiconductor device, and more particularly to a raw solution feeding system for a vaporizer which can effectively perform cleansing and cleaning the inside of a valve.

### Background Art

For the purpose of realizing the higher integration of a capacitor with respect to a semiconductor memory device or a semiconductor device using the capacitor such as an FeRAM (Ferroelectric-Random-Access-Memory), dielectric materials having a higher specific inductive capacity such as PZT [(Pb, Zr)TiO₃], BST [(Ba, Sr)TiO₃], STB [SrBi Ta_{y}O₂] and others have been examined. Although these dielectric materials are formed as a film on a wafer by a CVD method, (1) a by-product due to a film formation reaction or (2) a reaction product due to a reaction of molecules having the reaction activity with respect to a dielectric film formation material remaining in a pipe is generated, adheres to and is deposited in an apparatus or a pipe other than the wafer. Such a product which has adhered to and been deposited on a part other than the wafer becomes a particle generation source, thereby resulting in a reduction in yield ratio, an insufficient material supply flow quantity involved by clogging in a material feeding pipe or generation of a valve seat leakage due to deposition on a valve seat of a valve formed in the material feeding pipe system. Although Japanese Patent Application Laid-open No. 2001-176807 or the like proposes an in-apparatus cleaning method which solves these problems, there is no proposal concerning cleansing and cleaning the inside of a valve constituting an apparatus.

Such a system as shown in FIG. X has been conventionally adopted as a system which supplies a liquid raw material to a vaporizer. That is, two pipes 105a and 105b are inserted into a raw material tank 102. The pipe 105a is connected with a gas source through a valve 103c, a pipe 104b and a valve V01. A joint 103c is used to connect the pipe 105a and the valve V03 with each other. A joint is used to connect the pipe and the valve with each other in any other part.

On the other hand, the pipe 105b is connected with the vaporizer through a valve V04, a pipe 104a, a valve V05, a pipe 104c and a valve V07.

Further, a valve V02 is provided between the pipe 104b and the pipe 104a.

When supplying a raw solution to the vaporizer, the valve V02 and the valve V06 are closed, and the other valves are opened. An inert gas such as Ar is blown into the raw material tank 102. The raw solution in the raw material tank 102 is pressurized and supplied into the vaporizer 101 through the pipes and the valves with pressure.

When film formation is completed, cleaning of the system is performed. At this time, the valve V03, the valve V04 and the valve V07 are closed, and the other valves are opened. When the gas is introduced from the gas source, the gas passes through the valve V01, the v valve V02, the valve V05, the pipe 104c and the valve V06, thereby cleaning the inside of the valves and the inside of the pipe 104.

However, the inside of the pipe 103a, the valve V04 and the pipe 104a through which the raw solution has passed is not cleaned. That is, the inside of the pipe 104a serves as a dead zone, and the raw solution remains therein. Therefore, the inside of the pipe 104a must be cleaned after removing the joint 103b.

It is an object of the present invention to reduce a time required for cleansing and cleaning and achieve the reliability of an apparatus by providing a structure which facilitates cleansing and cleaning of the inside of valves in a piping system which constitutes an apparatus for manufacturing a semiconductor memory device or a semiconductor device using an FeRAM and is intended to feed a liquid material.

### Disclosure of the Invention

A raw solution feeding system for a vaporizer according to the present invention is characterized in that a plurality of passages and a plurality of valves communicating with the plurality of passages are formed in one polyhedral block and at least one surface can be directly connected with a liquid feeding tank or a liquid feed destination device through a sealing member.

A monoblock valve according to the present invention is characterized by using a monoblock valve, wherein the monoblock valve is a valve having a valve V1 which has one passage at one end and two passages at the other end, a valve V2 which has one passage at one end and one passage at the other end, and a valve V3 which has one passage at one end and one passage at the other end being formed in one block together with the passages,
the passage at one end of the valve V1, one passage at the other end of the valve V1, the passage at one end of the valve V2 and the passage at one end of the valve V3 respectively have opening sections A, B, C and D outside the block, and
the other passage at the other end of the valve V1, the passage at the other end of the valve V2 and the passage at the other end of the valve V3 communicate with each other.

A raw solution feeding system for a vaporizer according to the present invention is characterized by using a monoblock valve, wherein the monoblock valve is a valve having a valve V1 which has one passage at one end and three passages at the other end, a valve V2 which has one passage at one end and one passage at the other end, a valve V3 which has one passage at one end and one passage at the other end, and a valve V4 which has one passage at one end and two passages at the other end being formed in one block together with the passages,
the passage at one end of the valve V1, one passage at the other end of the valve V1, the passage at one end of the valve V2, the passage at one end of the valve V4 and one passage at the other end of the valve 4 respectively have opening sections A, C, B, D and E outside the block, and
another passage at the other end of the valve V1 communicates with the passage at the other end of the valve V2, still another passage at the other end of the valve V1 communicates with the passage at one end of the valve V3, and the passage at the other end of the valve V3 communicates with the other passage at the other end of the valve V4.

The raw solution feeding system for a vaporizer according to the present invention is characterized by using a monoblock valve therein, wherein the monoblock valve is a valve which has a valve V1 having one passage at one end and two passages at the other end, a valve V2 which has two passages at one end and one passage at the other end, a valve V3 which has one passage at one end and one passage at the other end, and a valve V4 which has one passage at one end and one passage at the other end being formed in one block together with the passages,
the passage at one end of the valve V1, one passage at one end of the valve V2, the passage at one end of the valve V3 and the passage at one end of the valve V4 respectively have opening sections E, C, D and B,
one passage at the other end of the valve V1 communicates with the passage at the other end of the valve V3, the other passage at the other end of the valve V1 communicates with the passage at the other end of the valve V2, and the other passage at one end of the valve V2 communicates with the passage at the other end of the valve V4, and
one end of the monoblock valve has an opening section A outside the block and the other end of the same communicates with a passage allowing the other passage at the other end of the valve V1 to communicate with the passage at the other end of the valve V2.

The raw solution feeding system for a vaporizer according to the present invention is characterized by using a monoblock valve therein, wherein the monoblock valve is a valve having a valve V1 which has one passage at one end and one passage at the other end, a valve V2 which has one passage at one end and three passages at the other end, a valve V3 which has one passage at one end and one passage at the other end, a valve V4 which has one passage at one end and two passages at the other end, and a valve V5 which has one passage at one end and one passage at the other end being formed in one block together with the passages,
the passage at one end of the valve V1, one passage at one end of the valve V2, the passage at one end of the valve V3, the passage at one end of the valve V4 and the passage at one end of the valve V5 respectively have opening sections B, A, D, E and F outside the block,
one passage at the other end of the valve V1 communicates with the passage at one end of the valve V2, one passage at the other end of the valve V2 communicates with the passage at the other end of the valve V3, the another passage at the other end of the valve V2 communicates with the passage at the other end of the valve V4, and the other passage at the other end of the valve 4 communicates with the passage at the other end of the valve V5, and
one end of the monoblock valve has an opening section C outside the block and the other end of the same communicates with still another passage at the other end of the valve V2.

The raw solution feeding system for a vaporizer according to the present invention is characterized in that a raw solution is prevented from dropping in the passages in the valve by the surface tension, and a purge gas is passed through the passages.

### (Effect)

In order to facilitate cleansing and cleaning the inside of the valve, a shut-off valve having a configuration with the following characteristics (1) to (4) is invented so that molecules having the reaction activity with respect to a dielectric film forming material in the valve is restricted from remaining.

### (1) Reducing retention zones

In order to effectively performing wet cleaning and gas purge cleaning in the passages in the valve, there is provided an ultrapure fluid valve using a metallic diaphragm which is designed so that inflow and outflow are aided by an effect of a potential head of a fluid in the valve while considering the characteristics of the fluid (the surface tension) and the gravitational force.

### (2) Providing a valve with a small internal volume.

There is provided an ultrapure fluid valve using a metallic diaphragm having an pipe (piping) internal diameter which is not greater than 2 mm and having a diaphragm external diametric dimension which is, e.g., not greater than φ14 mm which is appropriate to the piping internal diameter.

Further, its internal volume is reduced by configuring this ultrapure fluid valve in combination with a plurality of the same valve casings (Body).

### (3) Cleaning the inside of the valve

With respect to an ultrapure fluid valve using a metallic diaphragm constituted in piping which supplies a liquid material, the plurality of ultrapure fluid valves which supply a wet cleaning liquid and a fluid for gas purge cleaning are connected to a diaphragm chamber side, and an ultrapure fluid valve for collecting a fluid for wet cleaning and gas purge cleaning is further connected to the diaphragm chamber side, thereby assuredly performing wet cleaning and gas purge cleaning of the inside of the valve on the diaphragm chamber side of the ultrapure fluid valve using the metallic diaphragm constituted in piping which supplies the liquid material.

### (4) Method of connecting the valve with constituent members

In regard to connection between the ultrapure fluid valve using the metallic diaphragm constituted in piping which supplies a liquid material and constituent members such as an ultrapure liquid material feeding tank or a liquid material vaporizer, the valve is directly connected with the constituent members by using a metallic sealing member for the purpose of reducing the internal volume of piping. The metallic sealing member used in this example may be an O ring, a C ring, a metallic gasket or the like, and shapes/materials meeting utilization conditions can suffice.

### Brief Description of the Drawings

FIG. 1 is a view showing a monoblock valve according to Embodiment 1;
FIG. 2 is a view showing the monoblock valve according to Embodiment 1;
FIG. 3 is a view showing a monoblock valve according to Embodiment 2;
FIG. 4 is a view showing the monoblock valve according to Embodiment 2;
FIG. 5 is a view showing a monoblock valve according to Embodiment 3;
FIG. 6 is a view showing the monoblock valve according to Embodiment 3;
FIG. 7 is a view showing a monoblock valve according to Embodiment 4;
FIG. 8 is a view showing the monoblock valve according to Embodiment 4;
FIG. 9 is a view showing a monoblock valve according to Embodiment 5;
FIG. 10 is a view showing the monoblock valve according to Embodiment 5;
FIG. 11 is a view showing a utilization example of the monoblock valve according to Embodiments 4 and 5;
FIG. 12 is a view showing a raw solution feeding system using the monoblock valve according to the embodiment; and

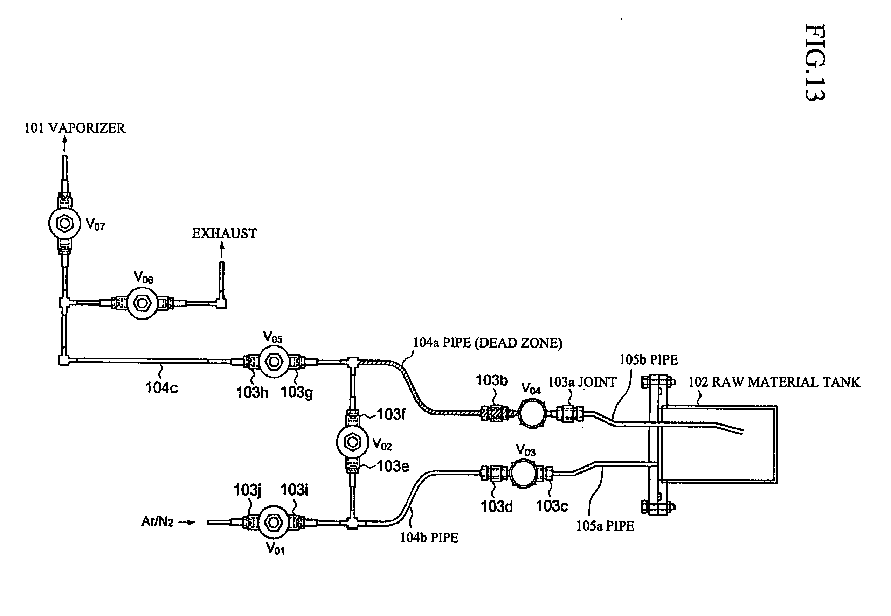

FIG. 13 is a view showing a raw solution feeding system according to a prior art.

### Description of Reference Numerals

1: block
21: a raw solution tank

### Best Mode for Carrying out the Invention

### (Embodiment 1)

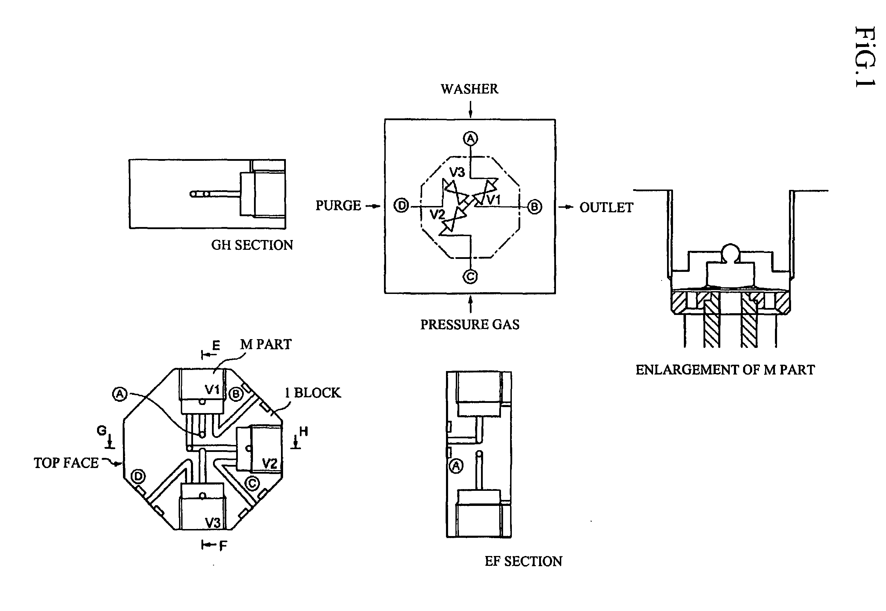

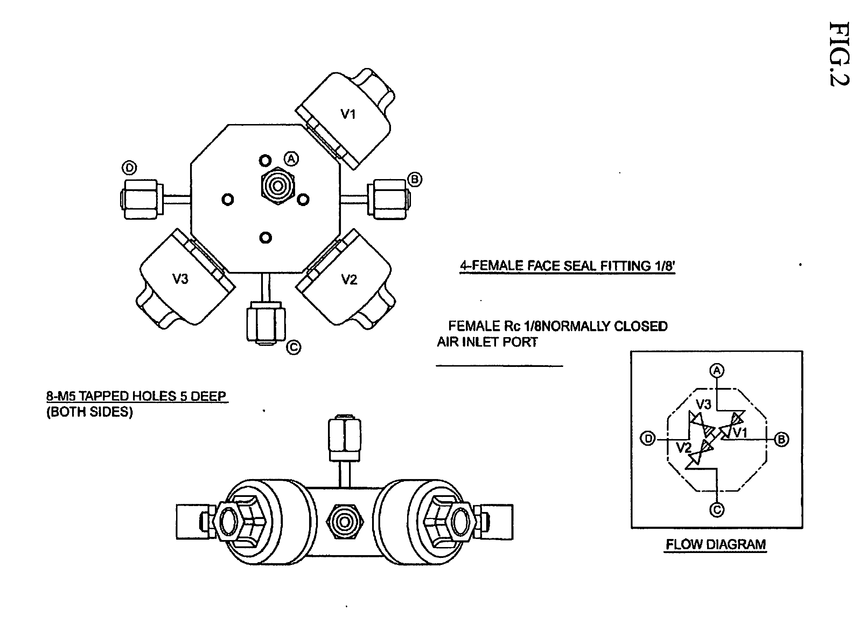

FIGS. 1 and 2 show a valve according to Embodiment 1.

In this example, there is provided a valve having a valve V1 which has one passage at one end and two passages at the other end, a valve V2 which has one passage at one end and one passage at the other end, and a valve V3 which has one passage at one end and one passage at the other end being formed in one block 1 together with the passages,
the passage at one end of the valve V1, the passage at the other end of the valve V1, the passage at one end of the valve V2 and the passage at one end of the valve V3 respectively have opening sections A, B, C and D, and
the other passage at the other end of the valve V1, the passage at the other end of the valve V2 and the passage at the other end of the valve V3 communicate with each other.

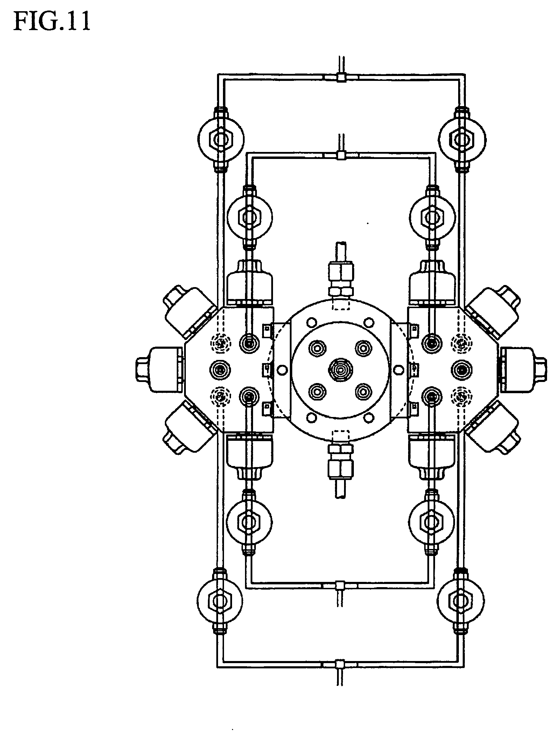

A monoblock valve X1 according to this example can be used as shown by a valve A depicted in FIG. 11.

A system shown in FIG. 11 is a system which supplies a raw solution to a vaporizer such as an MOCVD device.

The monoblock valve X1 is connected with a monoblock valve X2. The detail of the monoblock valve X2 will be described in conjunction with Embodiment 2.

When a pressure gas (e.g., an inert gas such as He and others) from V2 of the monoblock valve X1 is introduced, the pressure gas passes through V1 and is introduced into a raw solution tank 21 through a valve 4 of the monoblock valve X2. In the raw solution tank, a raw solution is pushed out by a pressure of the pressure gas, passed through monoblock valves X3 and X4 via the valve V1 of the monoblock valve X2, and supplied to a vaporizer.

Further, when the opening section A is determined as a washer inlet, the opening section C is determined as a pressure gas inlet, the opening section D is determined as a purge gas inlet and the opening section B is determined as an outlet, the monoblock valve according to this example can be also used for cleansing of a feeding system.

That is, a washer is first introduced from the valve V1 of the monoblock valve X1. The washer is introduced into the monoblock valve X3 through valves V3 and V2 of the monoblock valve X2. The washer further flows through a valve V2 of the monoblock valve X3 and a valve V2 of the monoblock valve X4. As a result, passages through which the raw solution has passed can be cleansed.

After cleansing using the washer, an inert gas such as an Ar gas is introduced from the valve V3 of the monoblock valve X1 as a purge gas. The passages are the same as those through which the washer has passed. The washer remaining in the passages is removed by this purge gas.

It is to be noted that purging using the purge gas can be performed before cleansing using the washer. In particular, it is effective when the raw solution is prevented from dropping due to the surface tension. When an internal diameter of each passage is set to, e.g., 2 mm or below, the raw solution exists in the passages without dropping. That is, it exists in a floating state. When the purge gas is caused to flow in this state, the raw solution existing in the passages can be readily separated from the inner wall of the passages. The separated raw solution is carried by the purge gas and discharged to the outside of the system together with the purge gas. When the raw solution is accidentally dropped, it is difficult to cause the raw solution staying at a point of fall to rise from this point of fall even if the purge gas is passed. Furthermore, even if a solvent which dissolves the raw solution is passed, there is no choice other than waiting for removal owing to diffusion of the raw solution. On the contrary, if the raw solution is in a state where it is floating by the surface tension, separation is very easy sine the force effecting separation is a very weak force, i.e., the surface tension.

It is to be noted that, as the raw solution, there are, e.g., Sr(DPM)₂, Bi(C₆H₅)₃, Ta (OC₂H₅)₅, THF and many other materials.

Moreover, as the washer, using a solvent which dissolves the raw solution can suffice.

It is preferable for the passage extending from the opening section A to the opening section B to be horizontal or declined. As a result, when supply of the raw solution is stopped, it is possible to prevent the raw solution from staying. In order to realize this, directions and angles of the passages in the monoblock valves are appropriately selected. Additionally, when the passages having such directions and angles as shown in FIG. 1 are adopted, it is good enough to attach the monoblock in such a manner that a top face indicated by an arrow faces an upper side.

Further, it is preferable for the opening section A to be formed on a flat surface. When the opening section A is formed on a flat surface, it is possible to achieve connection to any other device without a joint. It is good enough to attain connection to any other device through a sealing member. For example, flange connection using a bolt can be performed through a superelastic metallic pipe-shaped gasket formed of NiTi. When such connection is achieved, such a dead zone as described in conjunction with the prior art can be prevented from being generated. Cleansing of the raw solution feeding system can be greatly facilitated.

### (Embodiment 2)

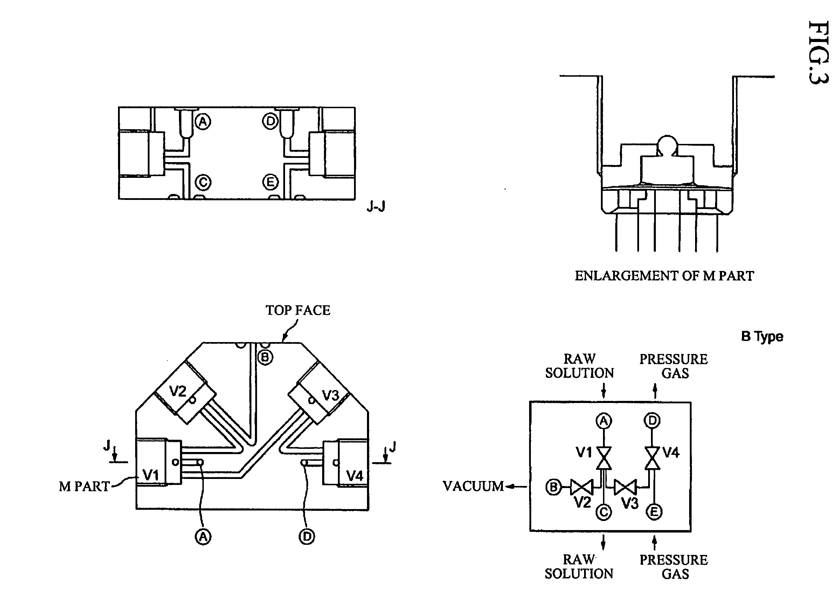

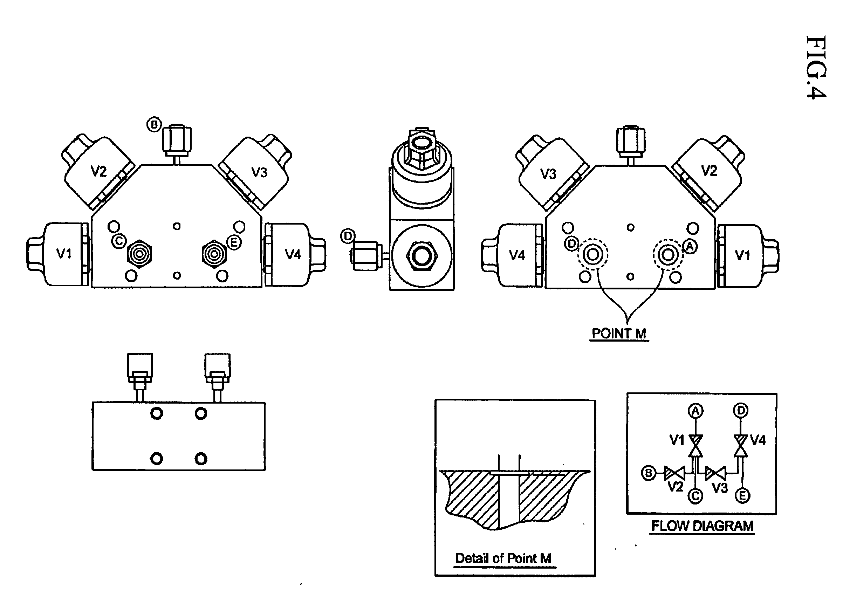

FIGS. 3 and 4 show a monoblock valve according to this embodiment.

In this example, there is provided a valve having a valve V1 which has one passage at one end and three passages at the other end, a valve V2 which has one passage at one end and one passage at the other end, a valve V3 which has one passage at one end and one passage at the other end, and a valve V4 which has one passage at one end and two passages at the other end being formed in one block together with the passages,
the passage at one end of the valve V1, one passage at the other end of the valve V1, the passage at one end of the valve V2, the passage at one end of the valve V4 and one passage at the other end of the valve V4 respectively have opening sections A, C, B, D and E outside the block, and
another passage at the other end of the valve V1 communicates with the passage at the other end of the valve V2, still another passage at the other end of the valve V1 communicates with the passage at one end of the valve V3, and the passage at the other end of the valve V3 communicates with the other passage at the other end of the valve V4.

The monoblock valve according to this example can be used with the opening section A determined as a raw solution inlet, the opening section B determined as a vacuum exhaust port, the opening section C determined as a raw solution outlet, the opening section D determined as a pressure gas outlet and the opening section E determine as a pressure gas inlet. FIG. 11 shows a utilization example. X2 denotes a monoblock valve according to this example. As a result, a raw solution can be fed to a vaporizer from a raw solution tank 21.

Incidentally, it is preferable for the passage extending from the opening section A to the opening section C to be horizontal or declined.

Furthermore, when the opening section A and the opening section D are formed on flat surfaces, the monoblock valve X2 can be connected to the raw solution tank 21 without a joint. Using the same sealing as that described in conjunction with Embodiment 1 can suffice.

### (Embodiment 3)

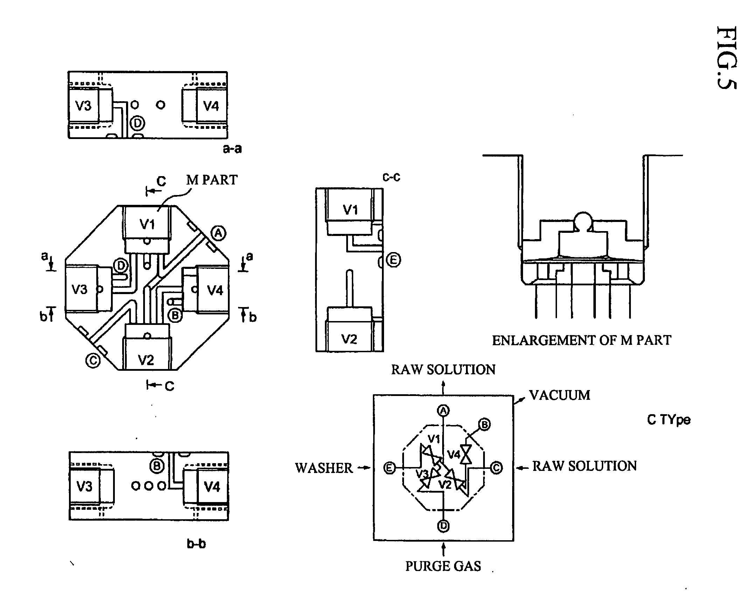

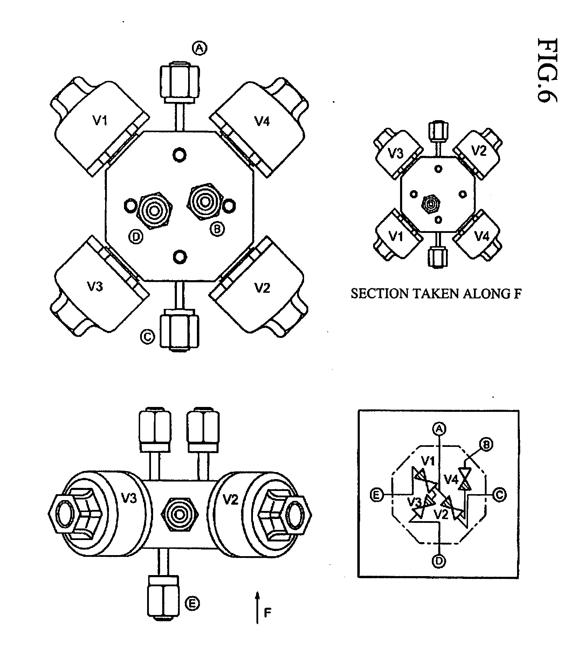

FIGS. 5 and 6 show a monoblock valve according to this example.

The monoblock valve according to this example is a valve having a valve V1 which has one passage at one end and two passages at the other end, a valve V2 which has two passages at one end and one passage at the other end, a valve V3 which has one passage at one end and one passage at the other end, and a valve V4 which has one passage at one end and one passage at the other end being formed in one block together with the passages,
the passage at one end of the valve V1, one passage at one end of the valve V2, the passage at one end of the valve V3 and the passage at one end of the valve V4 respectively have opening sections E, C, D and B outside the block,
one passage at the other end of the valve V1 communicates with the passage at the other end of the valve V3, the other passage at the other end of the valve V1 communicates with the passage at the other end of the valve V2, and the other passage at one end of the valve V2 communicates with the passage at the other end of the valve V4, and
one end of the monoblock valve has an opening section A outside the block, and the other end of the same communicates with a passage which allows the other passage at the other end of the valve V1 to communicate with the passage at the other end of the valve V2.

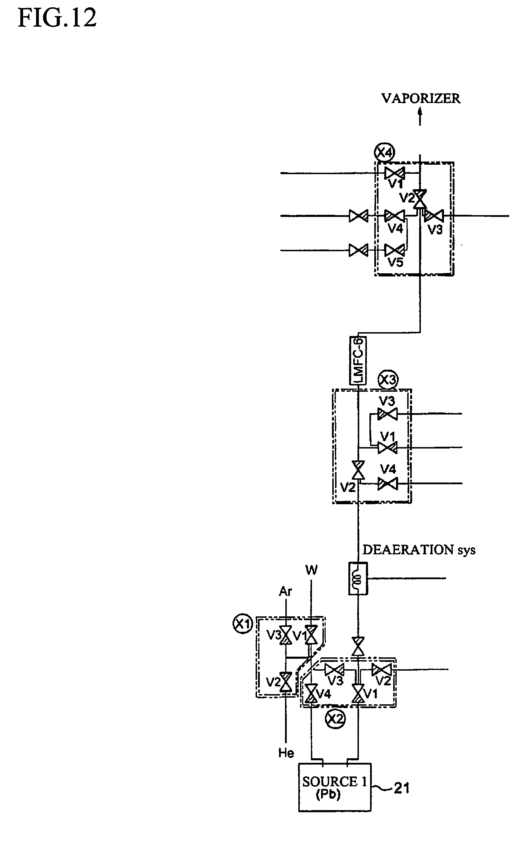

In the monoblock valve according to this example, it is preferable that the opening section A is determined as a raw solution outlet, the opening section B is determined as a vacuum exhaust port, the opening section C is determined as a raw solution inlet, the opening section D is determined as a purge gas inlet and the opening section E is determined as a washer inlet. As a result, such a utilization method as shown by X3 in FIG. 12 is possible.

Moreover, it is preferable for the passage extending from the opening section C to the opening section A to be horizontal or declined.

It is preferable that a massflow controller is provided between a raw solution source and the opening section C.

### (Embodiment 4)

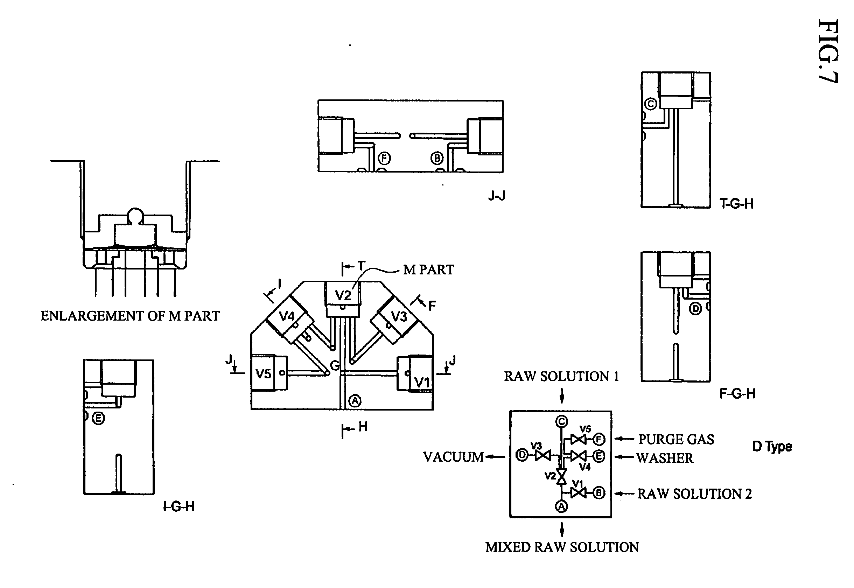

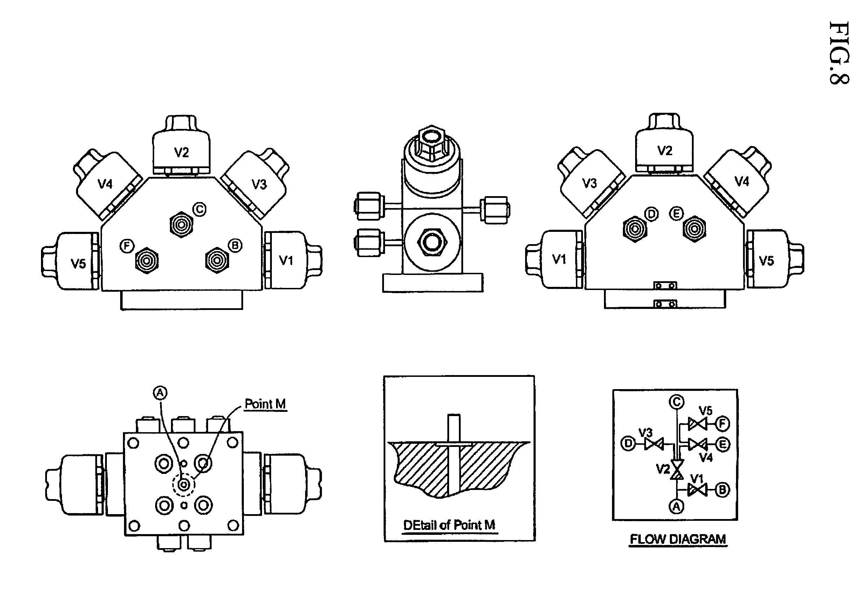

FIGS. 7 and 8 show a monoblock valve according to Embodiment 4.

The monoblock valve according to this example is a valve having a valve V1 which has one passage at one end and one passage at the other end, a valve V2 which has one passage at one end and three passages at the other end, a valve V3 which has one passage at one end and one passage at the other end, a valve V4 which has one passage at one end and two passages at the other end, and a valve V5 which has one passage at one end and one passage at the other end being formed in one block together with the passages,
the passage at one end of the valve V1, one passage at one end of the valve V2, the passage at one end of the valve V3, the passage at one end of the valve V4 and the passage at one end of the valve V5 respectively have opening sections B, A, D, E and F outside the block,
one passage at the other end of the valve V1 communicates with the passage at one end of the valve V2, one passage at the other end of the valve V2 communicates with the passage at the other end of the valve V3, another passage at the other end of the valve V2 communicates with the passage at the other end of the valve V4, and the other passage at the other end of the valve V4 communicates with the passage at the other end of the valve V5, and
one end of the monoblock valve has an opening section C outside the block and the other end of the same communicates with still another passage at the other end of the valve V2.

The opening section A is determined as a raw solution outlet, the opening section B is determined as a raw solution inlet, the opening section C is determined as the other raw solution inlet, the opening section D is determined as a vacuum exhaust port, the opening section E is determined as a washer inlet, and the opening section F is determined as a purge gas inlet, thereby enabling the usage shown in FIG. 12.

Additionally, it is preferable for the passage extending from the opening sections B and C to the opening section A to be horizontal or declined.

Further, it is preferable that a massflow controller is provided between a raw solution source and the opening section C.

There is provided a monoblock valve according to one of claims 10 to 12 having the above-described characteristics.

Furthermore, it is preferable that the opening section A is formed on a flat surface. As a result, the monoblock valve can be attached to a vaporizer without a joint.

### (Embodiment 5)

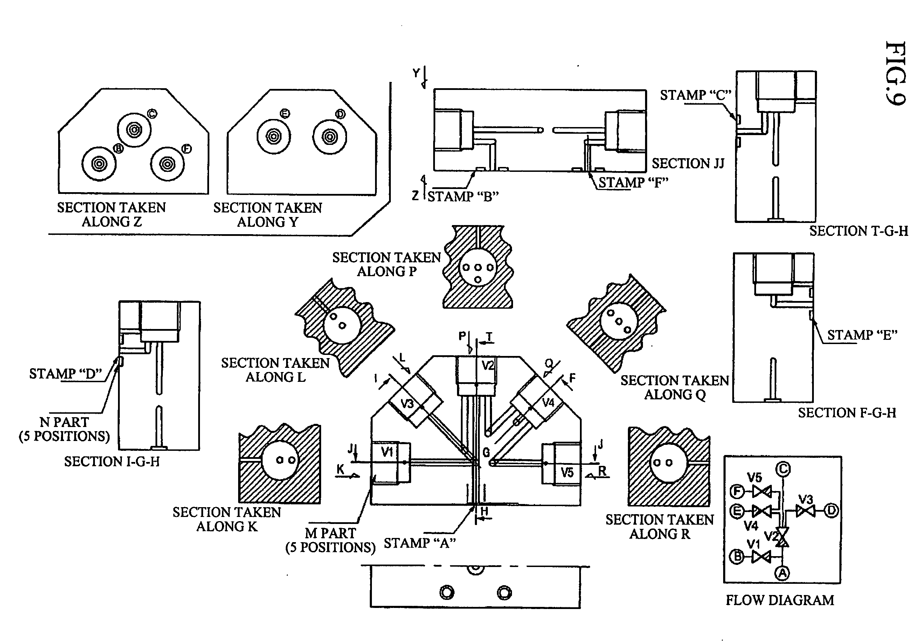

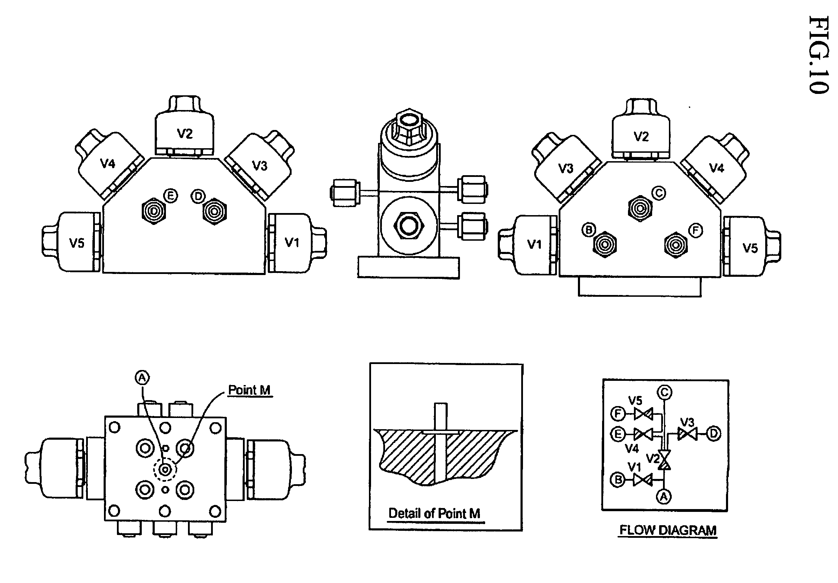

FIGS. 9 and 10 show a monoblock valve according to Embodiment 11.

The monoblock valve according to this example and the monoblock valve described in conjunction with Embodiment 4 form the mirror symmetry with a page space being determined as a mirror in a plan view.

Therefore, the monoblock valve according to Embodiment 4 and the monoblock according to this example can be symmetrically attached with respect to an attachment target as shown in FIG. 11.

In the foregoing embodiments, it is preferable for the valve to be a diaphragm valve.

Further, whether the raw solution can be held by the surface tension varies depending on the viscosity of the raw solution, the surface roughness of inner walls of the passages, inside diameters of the passages, a temperature of the raw solution and others, but it is preferable to set the inside diameter of each passage to be 2 mm or below in case of the raw solution for MOCVD. 1 mm or below is more preferable. The lower limit is a value with which processing is possible.

### Industrial Applicability

According to the present invention, cleansing the inside of the monoblock valve and the raw solution feeding line can be readily performed in a short period of time.

Further, a residual quantity of a by-product or a reaction product can be greatly reduced.

## Claims

1. A raw solution feeding system for a vaporizer **characterized in that** a plurality of passages and a plurality of valves communicating with the plurality of passages are formed in one polyhedral block, and a block valve in which at least one surface thereof can be directly connected with a liquid feeding tank or a liquid feed destination device through a sealing is attached to a raw solution tank or a vaporizer.

2. A raw solution feeding system for a vaporizer **characterized by** using a monoblock valve therein, wherein the monoblock valve is a valve having a valve V1 which has one passage at one end and two passages at the other end, a valve V2 which has one passage at one end and one passage at the other end and a valve V3 which has one passage at one end and one passage at the other end being formed in one block together with the passages,
the passage at one end of the valve V1, one passage at the other end of the valve V1, the passage at one end of the valve V2 and the passage at one end of the valve V3 respectively have opening sections A, B, C and D outside the block, and
the other valve at the other end of the valve V1, the passage at the other end of the valve V2 and the passage at the other end of the valve V3 communicate with each other.

3. The raw solution feeding system for a vaporizer according to claim 2, wherein the opening section A is determined as a cleaning agent inlet, the opening section C is determined as a pressure gas inlet, the opening section D is determined as a purge gas inlet, and the opening section B is determined as an outlet.

4. The raw solution feeding system for a vaporizer according to claim 3, wherein a passage extending from the opening section A to the opening section B is horizontal or declined.

5. The raw solution feeding system for a vaporizer according to one of claims 2 to 4, wherein the opening section A is formed on a flat surface.

6. A raw solution feeding system for a vaporizer **characterized by** using a monoblock valve therein, wherein the monoblock valve is a valve having a valve V1 which has one passage at one end and three passages at the other end, a valve V2 which has one passage at one end and one passage at the other end, a valve V3 which has one passage at one end and one passage at the other end, and a valve V4 which has one passage at one end and two passages at the other end being formed in one block together with the passages,
the passage at one end of the valve V1, one passage at the other end of the valve V1, the passage at one end of the valve V2, the passage at one end of the valve V4 and one passage at the other end of the valve V4 respectively have opening sections A, C, B, D and E outside the block, and
another passage at the other end of the valve V1 communicates with the passage at the other end of the valve V2, still another passage at the other end of the valve V1 communicates with the passage at one end of the valve V3, the passage at the other end of the valve V3 communicates with the other passage at the other end of the valve V4.

7. The raw solution feeding system for a vaporizer according to claim 6, wherein the opening section A is determined as a raw solution inlet, the opening section B is determined as a vacuum exhaust port, the opening section C is determined a raw solution outlet, the opening section D is determined as a pressure gas outlet and the opening section E is determined as a pressure gas inlet.

8. The raw solution feeding system for a vaporizer according to claim 7, wherein a passage extending from the opening section A to the opening section D is horizontal or declined.

9. The raw solution feeding system for a vaporizer according to claim 7 or 8, wherein the opening section A and the opening section D are formed on flat surfaces.

10. A raw solution feeding system for a vaporizer **characterized by** using a monoblock valve therein, wherein the monoblock valve is a valve having a valve V1 which has one passage at one end and two passages at the other end, a valve V2 which has two passages at one end and one passage at the other end, a valve V3 which has one passage at one end and one passage at the other end, and a valve V4 which has one passage at one end and one passage at the other end being formed in one block together with the passages,
the passage at one end of the valve V1, one passage at one end of the valve V2, the passage at one end of the valve V3 and the passage at one end of the valve V4 respectively have opening sections E, C, D and B outside the block,
one passage at the other end of the valve V1 communicates with the passage at the other end of the valve V3, the other passage at the other end of the valve V1 communicates with the passage at the other end of the valve V2, and the other passage at one end of the valve V2 communicates with the passage at the other end of the valve V4, and
one end of the monoblock valve has an opening section A outside the block, and the other end of the same communicates with a passage which allows the other passage at the other end of the valve V1 to communicate with the passage at the other end of the valve V2.

11. The raw solution feeding system for a vaporizer according to claim 10, wherein the opening section A is determined as a raw solution outlet, the opening section B is determined as a vacuum exhaust port, the opening section C is determined as a raw solution inlet, the opening section D is determined as a purge gas inlet, and the opening section E is determined as a washer inlet.

12. The raw solution feeding system for a vaporizer according to claim 11, wherein a passage extending from the opening section C to the opening section A is horizontal or declined.

13. The raw solution feeding system for a vaporizer according to one of claims 10 to 12, wherein a massflow controller is provided between a raw solution source and the opening section C.

14. A raw solution feeding system for a vaporizer **characterized by** using a monoblock valve therein, wherein the monoblock valve is a valve having a valve V1 which has one passage at one end and one passage at the other end, a valve V2 which has one passage at one end and three passages at the other end, a valve V3 which has one passage at one end and one passage at the other end, a valve V4 which has one passage at one end and two passages at the other end, and a valve V5 which one passage at one end and one passage at the other end being formed in one block together with the passages,
the passage at one end of the valve V1, one passage at one end of the valve V2, the passage at one end of the valve V3, the passage at one end of the valve V4 and the passage at one end of the valve V5 respectively have opening sections B, A, D, E and F outside the block,
one passage at the other end of the valve V1 communicates with the passage at one end of the valve V2, one passage at the other end of the valve V2 communicates with the passage at the other end of the valve V3, another passage at the other end of the valve V2 communicates with the passage at the other end of the valve V4, and the other passage at the other end of the valve V4 communicates with the passage at the other end of the valve V5, and
one end of the monoblock valve has an opening section C outside the block and the other end of the same communicates with still another passage at the other end of the valve V2.

15. The raw solution feeding system for a vaporizer according to claim 14, wherein the opening section A is determined as a mixed raw solution outlet, the opening section B is determined as a raw solution inlet, the opening section C is determined as another raw solution inlet, the opening section D is determined as a vacuum exhaust port, the opening section E is determined as a washer inlet, and the opening section F is determined as a purge gas inlet.

16. The raw solution feeding system for a vaporizer according to claim 15, wherein a passage extending from the opening sections B and C to the opening section A is horizontal or declined.

17. The raw solution feeding system for a vaporizer according to one of claims 10 to 12, wherein a massflow controller is provided between a raw solution source and the opening section C.

18. The raw solution feeding system for a vaporizer according to one of claims 14 to 17, wherein the opening section A is formed on a flat surface.

19. The raw solution feeding system for a vaporizer according to claim 18, wherein the vaporizer can be directly attached to the flat surface through a sealing member.

20. The raw solution feeding system for a vaporizer according to one of claims 1 to 19, wherein the valve is a diaphragm valve.

21. The raw solution feeding system for a vaporizer according to one of claims 1 to 20, wherein an internal diameter of the passage is not greater than 2 mm.

22. A method of cleaning a raw solution feeding system for a vaporizer **characterized in that** a raw solution is prevented from dropping in passages in a valve due to the surface tension, and a purge gas is passed through the passages.
